(19) Europäisches Patentamt
European Patent Office
Office européen des brevets

(11) **EP 1 760 477 A2**

(12) **EUROPEAN PATENT APPLICATION**

(43) Date of publication:
**07.03.2007 Bulletin 2007/10**

(51) Int Cl.:
***G01R 31/36*** *(2006.01)*

(21) Application number: **05258119.6**

(22) Date of filing: **30.12.2005**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **06.09.2005 JP 2005257665**

(71) Applicant: **Fujitsu Ltd.**
**Kawasaki-shi, Kanagawa 211-8588 (JP)**

(72) Inventor: **Okumura, Masafumi, c/o Fujitsu Limited**
**Kawasaka-shi, Kanagawa 211-8588 (JP)**

(74) Representative: **Stebbing, Timothy Charles et al**
**Haseltine Lake,**
**Imperial House,**
**15-19 Kingsway**
**London WC2B 6UD (GB)**

(54) **Anomaly detection method of battery pack, battery pack and electronic apparatus**

(57)     A structure of detecting an anomaly of the battery pack (2) including a plurality of battery cells (41a, 41b, 42a, 42b, 43a, 43b) connected in series or in parallel, which detects whether or not an impedance of at least one of battery cells deviates from a stipulated range. Also, a structure to detect whether or not an impedance change of at least one of battery cells exceeds a stipulated range.

## FIG.1

**Description**

**BACKGROUND OF THE INVENTION**

1. Field of the Invention

The present invention relates to an anomaly detection of a battery pack having a plurality of battery cells, more particularly, to an anomaly detection method of the battery pack, the battery pack and an electronic apparatus by detecting a conditional data such as an impedance of a battery cell and enabling the conditional data to be utilized in the anomaly judgment and charge/discharge control.

2. Description of the Related Art

The battery pack having a plurality of battery cells is often used for power sources of various electronic apparatus such as personal computers (PC) etc. Each of the battery cells in the battery pack may easily cause differences in deterioration because a plurality of the battery cells are combined as the battery pack. Due to the characteristics of the battery pack, it is difficult to detect imbalance of battery cells and anomaly of one side of a battery cell in a battery cell block.
Referring to such battery pack, there are publications disclosing structure to detect a battery anomaly by detecting the balance of currents flowing through each of the battery cells connected in parallel (Japanese Patent Application Laid-open Publication No. 2000-133318, paragraph [0051]), detection of battery voltage and impedance to judge whether or not a high-speed charge is possible (Japanese Patent Application Laid-open Publication No. 2004-215398, paragraphs [0036], [0037], [0039] and Fig. 3), measurement of current and voltage to protect from excess charging of the battery pack. (Japanese Patent Application Laid-open Publication No. H11(1999)-252809, paragraphs [0025], [0026], and Figs. 3, 4), and detection of an anomaly by monitoring each voltage of the battery cells comprising the battery pack (Japanese Patent Application Laid-open Publication No. 2004-31273, paragraph [0007] and Fig. 1).
Conventionally, there is a known method that, to detect an anomaly of the battery pack having a assembled battery having a plurality of battery cells, for example, by measuring time of increasing to a specified voltage during charging, and judging the battery pack as an anomaly if the specified voltage is not charged within a specified time. There is a protection means, for safety assurance of the battery pack, to permit charge/discharge by controlling the voltage of each of the battery cells within a specified voltage. However, it is difficult to detect an anomaly unless a battery cell in the battery pack is short-circuited, or a large difference generates between voltages of the battery cells.
As a structure of the battery pack, for example, in the case of using a assembled battery that makes three series by two parallel as for a battery cell, three battery cell blocks in which two battery cells are connected in parallel are constituted in series. In this case, it is difficult to detect an anomaly of a specific battery cell of the assembled battery because if one side of the battery cells constituting the battery cell block has anomaly, the voltage of the other side of the battery cells overrides and the battery cell block as a whole looks operating normally.
The above Japanese Patent Application Laid-open Publication No. 2000-133318 discloses the detection of an anomaly of such assembled battery, which detects a battery anomaly by monitoring the balance of current flowing in each of battery cells connected in parallel. In this structure, the anomaly cannot be detected unless there is a difference in deterioration between both sides of the battery cells.
In any case, an anomaly is not known unless there is an extreme failure such as inability of charge/discharge. Therefore, there is a disadvantage of allowing charging of a battery pack having imbalanced battery cell blocks caused by deterioration of a battery cell or a battery pack having a deteriorated battery cell.
The above problems are not disclosed in any one of Japanese Patent Application Laid-open Publication No. 2000-133318, Japanese Patent Application Laid-open Publication No. 2004-215398, Japanese Patent Application Laid-open Publication No. H11(1999)-252809, and Japanese Patent Application Laid-open Publication No. 2004-31273, and any solution for the problems are not taught or suggested in these publications.

**SUMMARY OF THE INVENTION**

In view of the above problems of the battery pack having a plurality of battery cells, it is a first object of the present invention to detect an anomaly in the battery pack.
It is a second object of the present invention to detect an anomaly of the battery pack at the side of the electronic apparatus which is connected to the battery pack or has the battery pack built-in.
In order to achieve the above first or second object, according to a first aspect of the present invention, there is provided an anomaly detection method of a battery pack with a plurality of battery cells connected in series or in parallel, comprising the step of detecting whether or not for an impedance of at least one of said battery cells to deviate from a stipulated range.

According to the above structure, by monitoring the impedance of a plurality of battery cells constituting the battery pack and detecting whether or not an impedance of at least one of battery cells deviates from a stipulated range, if the impedance deviates from the stipulated range, it is judged as an anomaly. Here, the stipulated range corresponds to a range of impedance in case where the battery cells works normally. In this case, the battery cells constituting the battery pack are formed by two or more battery cells and no matter how they are connected in serial or in parallel.

In order to achieve the above first or second object, according to a second aspect of the present invention, there is provided an anomaly detection method of a battery pack with a plurality of battery cells connected in series or in parallel, comprising the step of detecting whether or not for an impedance change of at least one of said battery cells to exceed a stipulated range.

According to the above structure, the condition of the battery cells can be known by monitoring an impedance change because the impedance of the battery cells varies by operating condition and using time. Detecting whether or not an impedance change of at least one of battery cells exceeds the stipulated range, and if the impedance change exceeds the stipulated range, it is judged as an anomaly. Here, the stipulated range corresponds to a range wherein the impedance change of the battery cell is considered normal. In this case, the impedance change includes an impedance difference between the battery cells.

In order to achieve the above object, the anomaly detection method of a battery pack may comprise the step of measuring an impedance of said battery cell. In this case, impedance can be obtained based on current and voltage, however there may be a structure to directly measure the impedance. An impedance change can be obtained from an impedance at differing time points or may be a impedance difference between between pluralities of the battery cells.

In order to achieve the above object, the anomaly detection method of a battery pack may comprise the step of measuring or predicting an impedance of said battery cell on the basis of current fluctuation amount of charging current of said battery cell and the corresponding voltage fluctuation amount of said battery cell. According to the above structure, impedance can be measured or predicted on the basis of voltage change against current change caused by the charging current.

In order to achieve the above object, the anomaly detection method of a battery pack may comprise the step of measuring or predicting an impedance of said battery cell on the basis of current fluctuation amount of discharging current of said battery cell and the corresponding voltage fluctuation amount of said battery cell. According to the above structure, impedance can be measured or predicted on the basis of voltage change against current change caused by the discharge current.

In order to achieve the above first object, according to a third aspect of the present invention there is provided a battery pack with a plurality of battery cells connected in series or in parallel, comprising a detection part detecting whether or not for an impedance of at least one of said battery cells to deviate from a stipulated range.

According to the above structure, the detection part disposed in the battery pack monitors impedance of a plurality of the battery cells constituting the battery pack, and detects whether or not impedance of at least one of battery cells deviates from the stipulated range. If the impedance deviates, it is judged as an anomaly. Here, the stipulated range or the battery cells are as described above.

In order to achieve the above first object, according to a forth aspect of the present invention there is provided a battery pack with a plurality of battery cells connected in series or in parallel, comprising a detection part detecting whether or not for an impedance change of at least one of said battery cells to exceed a stipulated range.

According to the above structure, the detection part disposed in the battery pack monitors an impedance change of a plurality of the battery cells constituting the battery pack, and detects whether or not the impedance change of at least one of battery cells exceeds the stipulated range. If the impedance change exceeds, it is judged as an anomaly. Here, the stipulated range or the battery cells are as described above.

In order to achieve the above object, the battery pack may comprise a measurement part measuring an impedance of said battery cell. According to this structure, the battery pack has the detection part disposed therein to measure impedance, thus the impedance can be monitored by the battery pack itself.

In order to achieve the above object, the battery pack may comprise a processing part calculating or predicting an impedance of said battery cell on the basis of current fluctuation amount of charging current of said battery cell and the corresponding voltage fluctuation amount of said battery cell.

In order to achieve the above object, the battery pack may comprise a processing part calculating or predicting an impedance of said battery cell on the basis of current fluctuation amount of discharging current of said battery cell and the corresponding voltage fluctuation amount of said battery cell.

In order to achieve the above object, the battery pack may prohibit either or both of charging and discharging of said battery cell on the basis of a detection result by said detection part.

In order to achieve the above second object, according to a fifth aspect of the present invention there is provided an electronic apparatus connected to a battery pack with a plurality of battery cells connected in series or in parallel, comprising a detection part detecting whether or not for an impedance of at least one of said battery cells to deviate from a stipulated range. According to this structure, the side of the electronic apparatus has the impedance detection part of the battery cells constituting the battery pack, thus the impedance is monitored at the side of the electronic apparatus.

In order to achieve the above second object, according to a sixth aspect of the present invention there is provided an electronic apparatus connected to a battery pack with a plurality of battery cells connected in series or in parallel, comprising a detection part detecting whether or not for an impedance change of at least one of said battery cells to exceed a stipulated range. According to this structure, the side of the electronic apparatus has the impedance change detection part of the battery cells constituting the battery pack, thus the impedance change is monitored at the side of the electronic apparatus.

In order to achieve the above object, the electronic apparatus may comprise a measurement part measuring an impedance of each said battery cell of said battery pack.

In order to achieve the above object, the electronic apparatus may comprise a processing part calculating or predicting an impedance of said battery cell on the basis of current fluctuation amount of charging current of said battery cell and the corresponding voltage fluctuation amount of said battery cell.

In order to achieve the above object, the electronic apparatus may comprise a processing part calculating or predicting an impedance of said battery cell on the basis of current fluctuation amount of discharging current of said battery cell and the corresponding voltage fluctuation amount of said battery cell.

In order to achieve the above object, the electronic apparatus may prohibit either or both of charging and discharging of said battery cell on the basis of a detection result by said detection part.

In order to achieve the above object, the electronic apparatus may comprise a receiving part receiving a data measured by said battery pack, corresponding to a transmitting part transmitting said data.

According to the present invention, as to the battery pack having an assembled battery comprised of a plurality of battery cells, imbalance of battery cells and anomaly of a specific battery cell can be detected, so that it is prevented for the battery pack to be used in the condition of anomaly. Thus it is possible to contribute to improving the safety of the battery pack.

Other objects, features and advantages of the present invention are more clearly understood by referring to the attached drawings and each of the embodiments.

## BRIEF DESCRIPTION OF THE DRAWINGS

Fig. 1 is an explanatory circuit diagram for a battery pack and its anomaly detection method according to a first embodiment of the present invention.

Fig. 2 is an explanatory circuit diagram for a battery pack and its anomaly detection method according to a first embodiment of the present invention.

Fig. 3 is an explanatory circuit diagram for a battery pack and its anomaly detection method according to a second embodiment of the present invention.

Fig. 4 is an explanatory circuit diagram for a battery pack and its anomaly detection method according to a second embodiment of the present invention.

Fig. 5 is a diagram showing a battery pack according to a third embodiment of the present invention.

Fig. 6 is a block diagram showing an anomaly detection part.

Fig. 7 is a flow chart showing an operation of anomaly detection.

Fig. 8 is a flow chart showing an operation at the time of anomalities.

Fig. 9 is an explanatory circuit diagram for a battery pack and its anomaly detection method according to a forth embodiment of the present invention.

Fig. 10 is a diagram showing a battery pack according to a fifth embodiment of the present invention.

Fig. 11 is a diagram showing a battery pack and an electronic apparatus according to a fifth embodiment of the present invention.

Fig. 12 is a diagram showing a battery pack and an electronic apparatus according to a sixth embodiment of the present invention.

Fig. 13 is a diagram showing a battery pack according to a seventh embodiment of the present invention.

Fig. 14 is a diagram showing an electronic apparatus according to other embodiments of the present invention.

## DESCRIPTION OF THE PREFERRED EMBODIMENT

[First Embodiment]

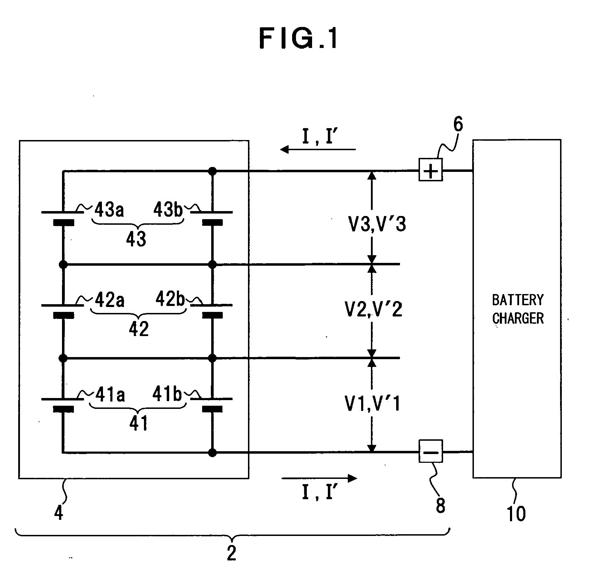

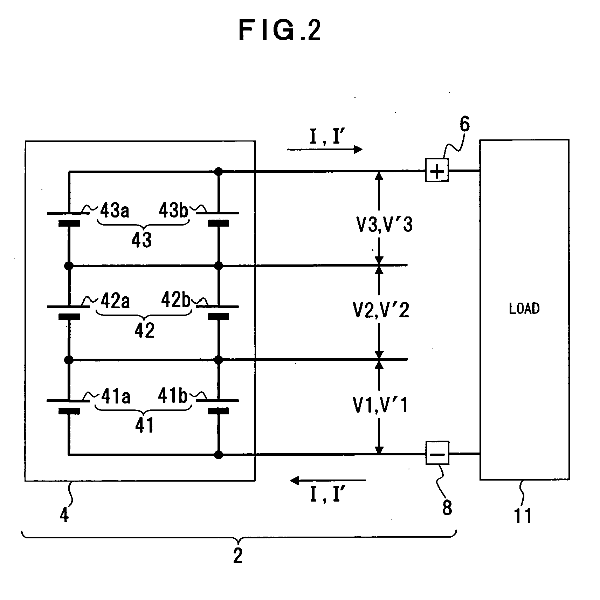

A first embodiment of the present invention is described referring to Fig. 1 and Fig. 2. Fig. 1 is an explanatory circuit diagram for a battery pack and its anomaly detection method in the case of using charging current. Fig. 2 is an explanatory circuit diagram for a battery pack and its anomaly detection method in the case of using discharging current.

A battery pack 2 has an assembled battery 4 and a pair of output terminals 6, 8. The assembled battery 4 has a plurality of battery cells 41a, 41b, 42a, 42b, 43a and 43b that arrange a positive electrode at the side of the output terminal 6 and a negative electrode at the side of the output terminal 8. As to the battery cells 41a, 41b, 42a, 42b, 43a and 43b, a pair of the parallel connected battery cells 41a and 41b (a battery cell block 41), a pair of the parallel connected battery cells 42a and 42b (a battery cell block 42) and a pair of the parallel connected battery cells 43a and 43b (a battery cell block 43) are connected in series. In other words, the assembled battery 4 has a structure of combination of two-parallel and three-series. Each of the battery cells 41a, 41b, 42a, 42b, 43a and 43b is a secondary battery having the functions of charging and discharging, which is, for example, structured by a lithium ion battery. Therefore, an accumulated voltage of the battery cell blocks 41, 42 and 43 is taken out between the output terminals 6 and 8.

According to the battery pack 2 shown in Fig. 1, assuming that a battery charger device 10 is connected to the output terminals 6, 8 so as to charge the assembled battery 4, the battery charger device 10 applies a voltage to each of the battery cell blocks 41, 42 and 43 and a charging current flows. In this case, a total current "I" as the charging current flows in the assembled battery 4.

Voltages of the battery cell blocks 41, 42 and 43 are measured in the case where this current "I" is flowing, and the measured voltages are assumed as V1, V2, and V3. Voltages of the battery cell blocks 41, 42 and 43 are measured in the case where current "I' " is flowing, and the measured voltages are assumed as V'1, V'2, and V'3.

As to each battery cell blocks 41, 42 and 43, impedance Z is calculated on the basis of the voltages V1, V2, V3, V'1, V'2, and V'3 and the currents "I" and "I'".

Impedance Z41 of the battery cell block 41, impedance Z42 of the battery cell block 42, and impedance Z43 of the battery cell block 43 can be thus defined by the following equations:

$$Z41 = (V'1 - V1) / (I' - I) \quad \ldots \quad (1)$$

$$Z42 = (V'2 - V2) / (I' - I) \quad \ldots \quad (2)$$

$$Z43 = (V'3 - V3) / (I' - I) \quad \ldots \quad (3)$$

In a normal state, the impedances Z41, Z42, and Z43 are considered as:

$$Z41 \fallingdotseq Z42 \fallingdotseq Z43$$

Accordingly:

$$(V'1 - V1) / (I' - I) \fallingdotseq (V'2 - V2) / (I' - I)$$
$$\fallingdotseq (V'3 - V3) / (I' - I) \quad \ldots \quad (4)$$

On the other hand, in an anomaly state, the impedances Z41, Z42, and Z43 are considered as:

$$Z41 \neq Z42 \neq Z43$$

Accordingly:

$$(V'1 - V1) / (I' - I) \neq (V'2 - V2) / (I' - I)$$
$$\neq (V'3 - V3) / (I' - I) \quad \ldots \quad (5)$$

As to the impedances Z41, Z42 and Z43, assuming an impedance change (difference) of the impedances Z41 and Z42 to be ΔZ412, assuming that of the impedances Z42 and Z43 to be ΔZ423, and assuming that of the impedances Z43 and Z41 to be ΔZ431, The impedance changes ΔZ412, ΔZ423 and ΔZ431 can be assumed in the following equations:

$$\Delta Z412 = Z41 - Z42$$
$$= \{(V'1 - V1)/(I' - I)\}$$
$$- \{(V'2 - V2)/(I' - I)\} \quad ... \quad (6)$$

$$\Delta Z423 = Z42 - Z43$$
$$= \{(V'2 - V2)/(I' - I)\}$$
$$- \{(V'3 - V3)/(I' - I)\} \quad ... \quad (7)$$

$$\Delta Z431 = Z43 - Z41$$
$$= \{(V'3 - V3)/(I' - I)\}$$
$$- \{(V'1 - V1)/(I' - I)\} \quad ... \quad (8)$$

In a normal state, the impedance changes ΔZ412, ΔZ423 and ΔZ431 are considered as:

$$\Delta Z412 \fallingdotseq \Delta Z423 \fallingdotseq \Delta Z431 \quad ... \quad (9)$$

On the other hand, in an anomaly state, the impedances ΔZ412, ΔZ423 and ΔZ431 are considered as:

$$\Delta Z412 \neq \Delta Z423 \neq \Delta Z431 \quad ... \quad (10)$$

Therefore, impedance change results in larger.

The above description is the case of the charging shown in Fig.1. Fig.2 shows that, instead of the battery charger device 10, a load 11 such as an electronic apparatus is connected to the output terminals 6, 8. In this case, although only a flowing direction of current "I" and "I'" is different from the case shown in Fig.1, the above calculations etc. described with the equations (1) through (10) can be applied in this case by measuring the voltages V1, V'1, V2, V'2, V3 and V'3 corresponding to the currents I and I'.

Now, the following is the meaning of measuring the impedances Z41, Z42 and Z43, and impedance changes ΔZ412, ΔZ423 and ΔZ431.

It is considered that an internal impedance increases in case where one side of the pairs of the battery cells constituting the battery cell blocks 41, 42 and 43 caused an anomaly, compared with the case where both of the pairs of the battery cells are in a normal state. In addition, there is a tendency that the internal impedance increases also in case where the deterioration of the battery cells advances. As a result, imbalance of battery cells balance or an anomaly of a specific battery cell can be predicted by measuring the impedances by each of the battery cell blocks 41, 42, and 43.

For example, it is impossible to interpret as an anomaly only because lithium ion battery having an internal impedance Zo=200 (mΩ) in a normal state indicates the voltages of 3(v) in the state where current is not flowing, and it is also impossible to interpret as an anomaly only because the voltage of 4 (v) is indicated in the state where charging current of 1 (A) is applied to charge. However, if a battery cell having a specified voltage of 3 (V) in the state where current does not flow indicates a voltage of 4 (V) by applying a charging current of 1 (A), an internal impedance Ze is defined as Ze = (4 - 3) / 1 = 1 (Q), hence Ze / Zo = 1 (Ω) / 200 (mΩ) = 5, which results in five time higher impedance of the normal impedance.

In this manner, even if an anomaly of the battery cell cannot be detected by comparing voltage or current simply, anomaly of the battery cell can be detected or judged by impedance or impedance change by calculating the impedance or the impedance change.

Accordingly, a state of anomaly of the battery pack 2 can be known based on the above described impedance data, and normal or anomaly can be judged as follows:

<1> By stipulating maximum tolerance range (Zra±ΔZa) for impedances Z41, Z42, Z43, it is judged as anomaly in case that any one of impedances Z41, Z42 or Z43 deviates from the maximum tolerance range (Zra±ΔZa). In this case, it may be judged as anomaly in case that all of impedances Z41, Z42, Z43 deviate from the maximum tolerance range (Zra±ΔZa).

<2> By stipulating maximum tolerance range ΔZb for impedance changes (differences) ΔZ412, ΔZ423 and ΔZ431, it is judged as anomaly in case that any one of impedance changes ΔZ412, ΔZ423 or ΔZ431 exceeds the maximum tolerance range ΔZb. In this case too, it may be judged as anomaly in case that all of impedance changes ΔZ412, ΔZ423 and ΔZ431 exceed the maximum tolerance range ΔZb.

According to the above structure, it is possible to detect accurately the state such as imbalance of the battery cells, anomaly of the battery cell, etc. of the battery pack 2 comprising an assembled battery. It is possible to prevent from using anomalous battery in advance. Thus it is possible to contribute to improving the safety of the battery pack.

[Second Embodiment]

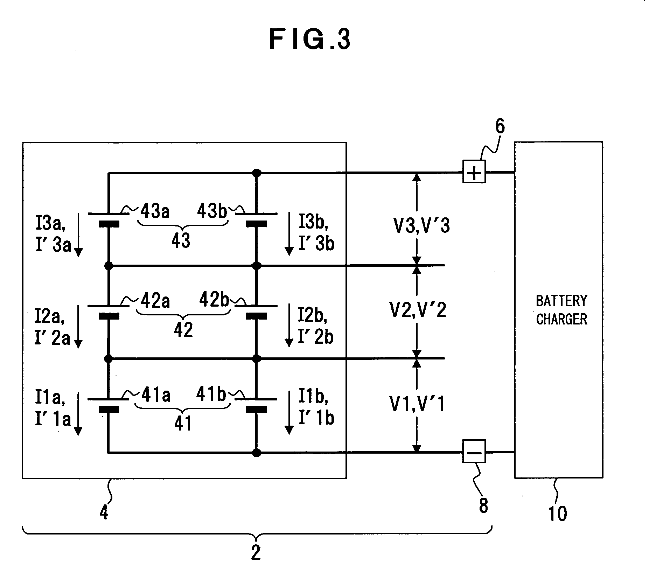

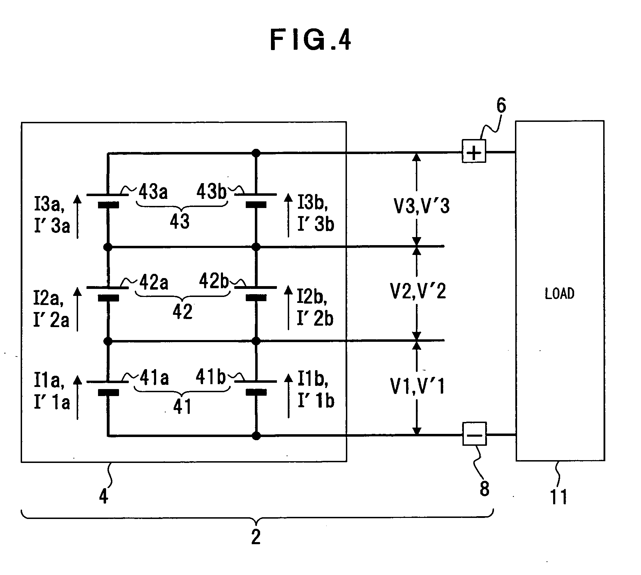

Next, a second embodiment of the present invention is described referring to Fig. 3 and Fig. 4. Fig. 3 is an explanatory circuit diagram for a battery pack and its anomaly detection method in the case of using charging current. Fig. 4 is an explanatory circuit diagram for a battery pack and its anomaly detection method in the case of using discharging current. Same reference numerals are used in Fig. 3 and Fig. 4 for the same constituents in Fig. 1 and Fig. 2.

A battery pack 2 according to the second embodiment is the same as the first embodiment so that description for each of the constituents of the battery pack is omitted here.

According to this embodiment, currents of each of the battery cells 41a, 41b, 42a, 42b, 43a and 43b and voltages of the battery cell blocks 41, 42, and 43 are measured. Impedance is calculated by measuring currents flowing in each of the battery cells 41a, 41b, 42a, 42b, 43a and 43b. In the first embodiment, the total current "I" of the battery pack 2 is measured, though in this embodiment, each of current flowing in each of the battery cells 41a, 41b, 42a, 42b, 43a and 43b is measured.

In this embodiment, voltages of the battery cell blocks 41, 42, and 43 are measured as V1, V2, and V3 respectively. Currents of the battery cells 41a, 41b, 42a, 42b, 43a and 43b are measured as I1a, I1b, I2a, I2b, I3a, and I3b, respectively, against the voltages V1, V2 and V3 of each of the battery cell blocks 41, 42 and 43. Also, currents of the battery cells 41a, 41b, 42a, 42b, 43a and 43b are measured as I'1a, I'1b, I'2a, I'2b, I'3a, and I'3b, respectively, against voltages V'1, V'2 and V'3 of each of the battery cell blocks 41, 42 and 43. Based on the measurements, impedances of the battery cells 41a, 41b, 42a, 42b, 43a, and 43b are calculated as Z1a, Z1b, Z2a, Z2b, Z3a, and Z3b. The impedances Z1a, Z1b, Z2a, Z2b, Z3a, and Z3b are defined by the following equations:

$$Z1a = (V'1 - V1) / (I'1a - I1a) \ldots (11)$$

$$Z1b = (V'1 - V1) / (I'1b - I1b) \ldots (12)$$

$$Z2a = (V'2 - V2) / (I'2a - I2a) \ldots (13)$$

$$Z2b = (V'2 - V2) / (I'2b - I2b) \ldots (14)$$

$$Z3a = (V'3 - V3) / (I'3a - I3a) \ldots (15)$$

$$Z3b = (V'3 - V3) / (I'3b - I3b) \ldots (16)$$

In a normal state, these impedances Z1a, Z1b, Z2a, Z2b, Z3a, and Z3b can be defined as follows:

$$Z1a \fallingdotseq Z1b \fallingdotseq Z2a \fallingdotseq Z2b \fallingdotseq Z3a \fallingdotseq Z3b$$

$$
\begin{aligned}
(V'1 - V1) / (I'1a - I1a) \\
\fallingdotseq (V'1 - V1) / (I'1b - I1b) \\
\fallingdotseq (V'2 - V2) / (I'2a - I2a) \\
\fallingdotseq (V'2 - V2) / (I'2b - I2b) \\
\fallingdotseq (V'3 - V3) / (I'3a - I3a) \\
\fallingdotseq (V'3 - V3) / (I'3b - I3b) \quad \ldots (17)
\end{aligned}
$$

On the other hand, in the case of an anomaly state: Impedance of the normal operating period of

$$Z1a \fallingdotseq Z1b \fallingdotseq Z2a \fallingdotseq Z2b \fallingdotseq Z3a \fallingdotseq Z3b$$

is changed into the following inequalities:

$$Z1a \neq Z1b \neq Z2a \neq Z2b \neq Z3a \neq Z3b \quad \ldots (18)$$

In addition, as to the above impedances Z1a, Z1b, Z2a, Z2b, Z3a, and Z3b, for example, impedance changes (differences) for every battery cell blocks 41, 42, 43 are assumed as $\Delta Z1ab$, $\Delta Z2ab$, and $\Delta Z3ab$. The impedance charges (differences) $\Delta Z1ab$, $\Delta Z2ab$, and $\Delta Z3ab$ are defined as:

$$
\begin{aligned}
\Delta Z1ab = Z1a - Z1b \\
= \{(V'1 - V1) / (I'1a - I1a)\} \\
- \{(V'1 - V1) / (I'1b - I1b)\} \quad \ldots (19)
\end{aligned}
$$

$$
\begin{aligned}
\Delta Z2ab = Z2a - Z2b \\
= \{(V'2 - V2) / (I'2a - I2a)\} \\
- \{(V'2 - V2) / (I'2b - I2b)\} \quad \ldots (20)
\end{aligned}
$$

$$
\begin{aligned}
\Delta Z3ab = Z3a - Z3b \\
= \{(V'3 - V3) / (I'3a - I3a)\} \\
- \{(V'3 - V3) / (I'3b - I3b)\} \quad \ldots (21)
\end{aligned}
$$

The impedance changes, $\Delta Z1ab$, $\Delta Z2ab$, and $\Delta Z3ab$ in the normal state are as follows:

$$\Delta Z1ab \fallingdotseq \Delta Z2ab \fallingdotseq \Delta Z3ab \quad \ldots (22)$$

The above equation is changed into the following inequalities in an anomaly state resulting in large changes in impedances:

$$\Delta Z1ab \neq \Delta Z2ab \neq \Delta Z3ab \quad ... \quad (23)$$

The above description is the case of the charging shown in Fig.3. Fig.4 shows that, instead of the battery charger device 10, a load 11 such as an electronic apparatus is connected to the output terminals 6, 8. In this case, although only a flowing direction of currents I1a, I1b, I2a, I2b, I3a, I3b, I'1a, I'1b, I' 2a, I' 2b, I' 3a and I' 3b is different from the case shown in Fig.3, the above calculations etc. described with the equations (11) through (23) can be applied in this case by measuring the voltages V1, V'1, V2, V'2, V3 and V'3 corresponding to the currents I1a, I1b, I2a, I2b, I3a, I3b, I'1a, I'1b, I' 2a, I' 2b, I' 3a and I'3b.

Accordingly, a state of anomaly of the battery pack 2 can be known based on the above described impedance data, and normal or anomaly can be judged as follows:

<3> By stipulating maximum tolerance range (Zrc$\pm\Delta$Zc) for impedances Z1a, Z1b, Z2a, Z2b, Z3a and Z3b, it is judged as anomaly in case that any one of impedances Z1a, Z1b, Z2a, Z2b, Z3a or Z3b deviates from the maximum tolerance range (Zrc$\pm\Delta$Zc). In this case, it may be judged as anomaly in case that all of impedances Z1a, Z1b, Z2a, Z2b, Z3a and Z3b deviate from the maximum tolerance range (Zrc$\pm\Delta$Zc).
<4> By stipulating maximum tolerance range $\Delta$Zd for impedance changes (differences) $\Delta$Z1ab, $\Delta$Z2ab and $\Delta$Z3ab, it is judged as anomaly in case that any one of impedance changes $\Delta$Z1ab, $\Delta$Z2ab or $\Delta$Z3ab exceeds the maximum tolerance range $\Delta$Zd. In this case too, it may be judged as anomaly in case that all of impedance changes $\Delta$Z1ab, $\Delta$Z2ab and $\Delta$Z3ab exceed the maximum tolerance range $\Delta$Zd.

Also, according to the above structure, it is possible to detect accurately the state such as imbalance of the battery cells, anomaly of the battery cell, etc. of the battery pack 2 comprising an assembled battery 4. It is possible to prevent from using anomalous battery in advance. Thus it is possible to contribute to improving the safety of the battery pack.

[Third Embodiment]

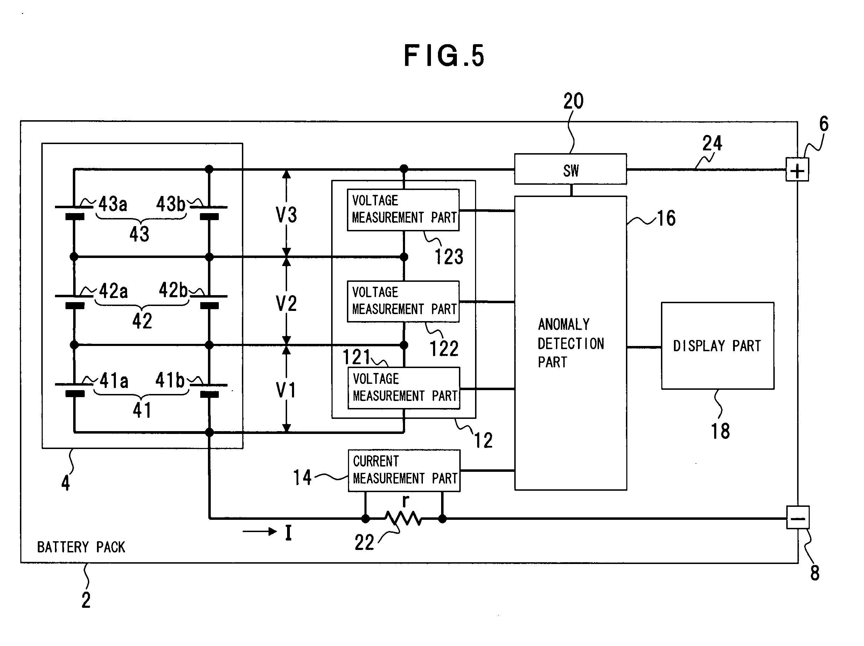

Next, a third embodiment of the present invention is described referring to Fig. 5. Fig. 5 is a diagram showing a configuration example of a battery pack. Same reference numerals are used in Fig. 5 for the same constituents in Fig. 1.
This battery pack 2 is equipped with an assembled battery 4, and houses a voltage measurement part 12, a current measurement part 14, an anomaly detection part 16, a display part 18 and a switching part (SW) 20, as a detection part which detects anomaly of the assembled battery 4 and a processing part which calculates impedance and impedance change. The voltage measurement part 12 measures voltages of the assembled battery 4. The current measurement part 14 measures current of the assembled battery 4. The anomaly detection part 16 detects anomaly of the assembled battery 4 based on data measured by the voltage measurement part 12 and the current measurement part 14. The display part 18 displays the anomaly. The SW 20 is controlled by output of the anomaly detection part 16. In this battery pack 2, positive voltage of the assembled battery 4 is taken out from the output terminal 6 and negative voltage of that from the output terminal 8. At the time of discharging, the output terminals 6, 8 connect with an electronic apparatus such as a personal computer (PC) etc. as a load which is an object for power feeding. At the time of charging, the output terminals 6, 8 connect with the above described battery charger device 10.
Structure of the assembled battery 4 is as described above (refer to Fig. 1). As a rechargeable secondary battery, for example, a lithium ion battery is used for each of the battery cells 41a, 41b, 42a, 42b, 43a, and 43b.
The voltage measurement part 12 is comprised of voltage measurement parts 121, 122, and 123 corresponding to each of the battery cell blocks 41, 42, and 43, which measures voltages respectively. Each of the voltage measurement parts 121, 122, and 123 is composed of, for example, voltmeter.
A current sensing resistor 22 is connected between the negative electrode side of the assembled battery 4 and the output terminal 8. The current "I" flowing through the current sensing resistor 22 is measured by the current measurement part 14. In this case, assuming that "I" represents current flowing the current sensing resistor 22, and "r" represents a value of resistance of the current sensing resistor 22, a voltage drop of "r · I" is generated. By using the voltage drop of "r · I", the current is measured by the measurement of the voltages. The current "I" is applied to the anomaly detection part 16 as a data for calculation and is used for detecting state of an anomaly etc.
The anomaly detection part 16 is, for example, composed of a microcomputer, which calculates the above described impedances based on the voltages V1, V2, and V3 of the battery cell blocks 41, 42, and 43, and a total current "I" or measurement data of each of currents flowing through the battery cells 41a, 41b, 42a, 42b, 43a, and 43b, judges whether the state is normal or anomaly based on the result of the calculation, generates its notification display output, and performs open/close control of the SW 20. Any one of the above described processes <1> through <4> can be used to judge the impedance.

The display part 18 is comprised of a liquid crystal display (LCD) or light emitting diodes to indicate message representing normal or anomaly and warning.

The SW 20 is opened or closed by the output from the anomaly detection part 16. This means that the SW 20 turns off a line 24 between the positive electrode side of the assembled battery 4 and the output terminal 6 at the time of anomalities.

In this battery pack 2, the battery charger device 10 (refer to Fig. 1 and Fig. 3) is connected with the output terminals 6, 8 at the time of charging; the load 11 such as an electronic apparatus etc. is connected with the output terminals 6, 8 at the time of discharging (refer to Fig. 2 and Fig. 4).

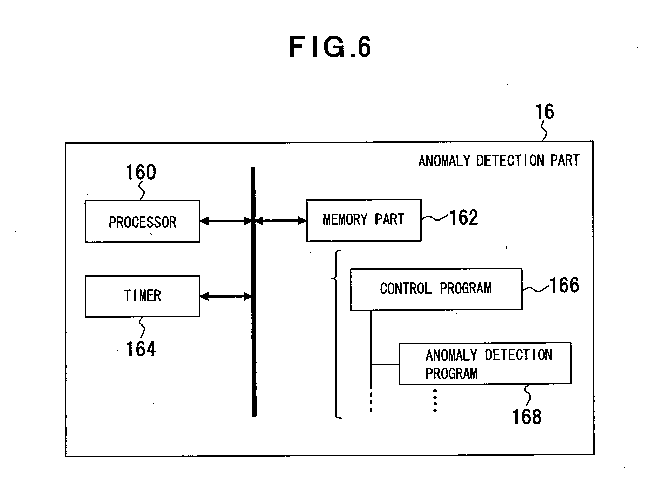

Next, a configuration example of the anomaly detection part 16 is described referring to Fig. 6. Fig. 6 is a block diagram showing the configuration example of the anomaly detection part 16. In Fig. 6, the same reference numerals are used for the same constituents in Fig. 5.

This anomaly detection part 16 is, as described above, comprised of the microcomputer having a processor 160, a memory part 162, and a timer 164 etc. The processor 160 performs various programs stored in the memory part 162, which executes the processes of the above-described calculation, anomaly judgment, and switching control etc. The memory part 162 has a read only memory (ROM) and a random access memory (RAM) as storage medium. The ROM stores a control program 166 and an anomaly detection program 168 etc. The RAM stores data of voltages measured by the voltage measurement parts 121, 122, and 123, and data of a current by the current measurement part 14. The timer 164 is timing means to generate a measurement timing etc. The timing generated at a predetermined time interval is used to perform measurement of voltages and currents, calculation of impedance and so on.

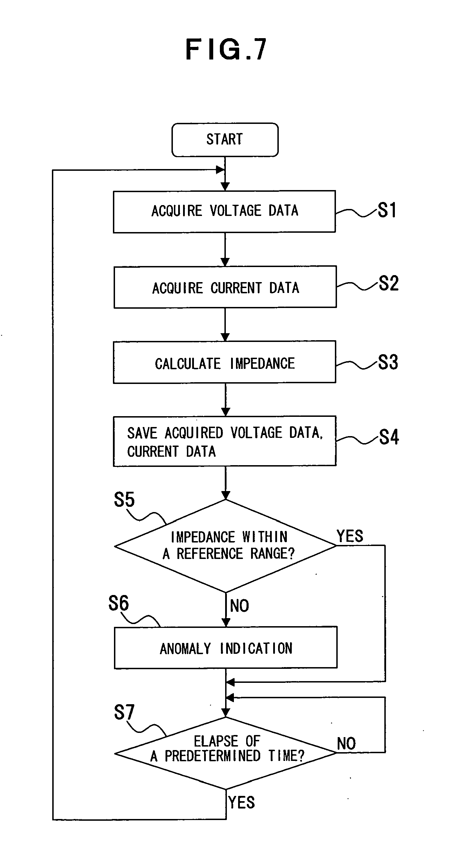

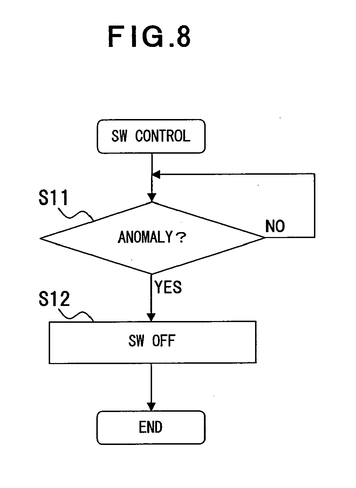

Next, an example of anomaly detection of the battery pack 2 and its corresponding process is described referring to Fig. 7 and Fig. 8. Fig. 7 is a flow chart showing measurement of impedance and process corresponding to the measurement result. Fig. 8 is a flow chart showing the switching control at the time of anomalities. The process performed by this flow chart corresponds to the above described process <1> or <3> to explain Fig. 1 through Fig. 4.

The output terminals 6, 8 of the battery pack 2 shown in Fig. 5 are connected with the battery charger device 10 (refer to Fig. 1) to set in charging condition, or the output terminals 6, 8 of the battery pack 2 are connected with a load 11 (refer to Fig. 2) to set in discharging condition. In these setting conditions, a voltage data is obtained at an optional point in time (Step S1) and a current data is obtained (Step S2).

In this case, a total current "I" is obtained, and the voltages V1, V2, and V3 are obtained from the battery cell blocks 41, 42, and 43 while the current "I" is flowing. And another current "I' " is obtained at an optional point in time different from the point in time where the current "I" was obtained and the voltages of V' 1, V' 2, and V' 3 are obtained while the current "I' " is flowing. Impedance Z is calculated based on the voltage data and the current data (Step S3). As to the calculation of the impedance Z, impedances Z41, Z42, and Z43 are calculated using the equations (1) through (3).

After the impedances are calculated, the obtained voltage data and the current data are saved by a data-saving memory area of the RAM (Step S4), it is judged whether or not the calculated impedances Z41, Z42, and Z43 are within a reference range, that is, the above described maximum tolerance range (Zra±ΔZa) (Step S5).

If any one of the impedances Z41, Z42, and Z43 deviates from the maximum tolerance range (Zra±ΔZa), an output indicating an anomaly is generated and the anomaly is noticed (Step S6) and the flow reaches to Step S7. If the impedances Z41, Z42, Z43 are within the reference range (Zra±ΔZa), the flow jumps to Step S7 by passing Step S6, and elapse of time is monitored at Step S7 and the flow returns to Step S1 after the predetermined time is elapsed.

Referring to steps S1 through S3, there is another method by obtaining voltages V1, V2, and V3 of the battery cell blocks 41, 42, and 43, and obtaining currents I1a, I1b, I2a, I2b, I3a, and I3b for each of the battery cells 41a, 41b, 42a, 42b, 43a, and 43b respectively, at an optional point in time, and by obtaining voltages V'1, V'2, and V'3, and obtaining currents I' 1a, I'1b, I'2a, I'2b, I'3a, and I'3b at a point in time different from the above optional point in time, impedance Z can be also calculated based on the voltage data and the current data. (Step S3). As to the calculation of the impedance Z, the impedances Z1a, Z1b, Z2a, Z2b, Z3a, and Z3b can be calculated using the equations (11) through (16).

After the impedances are calculated, the obtained voltage data and the current data are saved by a data-saving memory area of the RAM (Step S4), it is judged whether or not any one of the calculated impedances Z1a, Z1b, Z2a, Z2b, Z3a, and Z3b are within a reference range, that is, the above described maximum tolerance range (Zrc±ΔZc) (Step S5). In short, it is judged whether or not the condition is normal or anomaly based on detected condition. Depending on this judgment result, further steps S6 and S7 are performed.

By performing the above steps in the battery pack 2, anomaly can be found in the display part 18 disposed in the battery pack 2. This notification becomes opportunity of exchange of the battery pack 2, therefore safety is improved.

As Fig. 8 shows, depending on the judgment of normal or anomaly as condition judgment (Step S11), in case where an anomaly is detected, on the basis of output of the judgment, the SW 20 is switched to turn off so as to be in the state of disconnection (OFF), the line 24 is disconnected (Step S12). According to these steps, any of charge or discharge cannot be performed in the battery pack 2 after an anomaly is detected, therefore safety is assured.

[Fourth Embodiment]

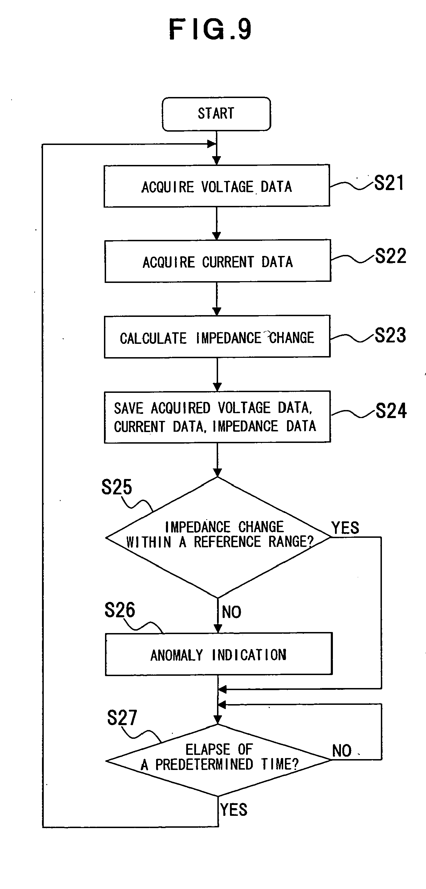

Next, a fourth embodiment of the present invention is described referring to Fig. 9. Fig. 9 is a flow chart showing measurement of impedance and process corresponding to the measurement result, which is another example of anomaly detection of the battery pack 2 and its corresponding process shown in Fig. 7. Steps in this flow chart correspond to the above described <2> or <4> corresponding to explanation for Fig. 1 through Fig. 4.

The output terminals 6, 8 of the battery pack 2 shown in Fig. 5 are connected with the battery charger device 10 (refer to Fig. 1) to set in charging condition, or the output terminals 6, 8 of the battery pack 2 are connected with a load 11 (refer to Fig. 2) to set in discharging condition. In these setting conditions, a voltage data is obtained at an optional point in time (Step S21) and a current data is obtained (Step S22).

In this case, a total current "I" is obtained, and the voltages V1, V2, and V3 are obtained from battery cell blocks 41, 42, and 43 while the current "I" is flowing. And another current "I' " is obtained at an optional point in time different from the point in time where the current "I" was obtained and the voltages of V'1, V' 2, and V' 3 are obtained while the current "I' " is flowing. Based on the voltage data and the current data, Impedance Z is calculated to calculate impedance change $\Delta Z$ (Step S23). As to the calculation of the impedance Z and the impedance change $\Delta Z$, impedances Z41, Z42, and Z43 and impedance changes $\Delta Z412$, $\Delta Z423$, and $\Delta Z431$ are calculated using the equations (1) through (8).

After the impedance changes are calculated, the obtained voltage, current and impedance data are saved by a data-saving memory area of the RAM (Step S24), it is judged whether or not any one of the calculated impedance changes $\Delta Z412$, $\Delta Z423$, and $\Delta Z431$ exceeds a reference range, that is, the above described maximum tolerance range $\Delta Zb$ (Step S25).

If any one of the impedance changes $\Delta Z412$, $\Delta Z423$, and $\Delta Z431$ exceeds a reference range $\Delta Zb$, an output indicating an anomaly is generated and the anomaly is noticed (Step S26) and the flow reaches to Step S27. If the impedance changes $\Delta Z412$, $\Delta Z423$, and $\Delta Z431$ are within the reference range $\Delta Zb$, the flow jumps to Step S27 by passing Step S26, and elapse of time is monitored at Step S27 and the flow returns to Step S21 after the predetermined time is elapsed.

Referring to steps S21 through S23, there is another method by obtaining voltages V1, V2, and V3 of the battery cell blocks 41, 42, and 43, and obtaining currents I1a, I1b, I2a, I2b, I3a, and I3b for each of battery cells 41a, 41b, 42a, 42b, 43a, and 43b respectively, at an optional point in time, and by obtaining voltages V'1, V'2, and V'3, and obtaining currents I'1a, I'1b, I'2a, I'2b, I'3a, and I'3b at a point in time different from the above optional point in time, impedance Z and impedance change $\Delta Z$ can be also calculated based on the voltage data and the current data. (Step S23). As to the calculation of the impedance change $\Delta Z$, the impedances Z1a, Z1b, Z2a, Z2b, Z3a, and Z3b and the impedance changes $\Delta Z1ab$, $\Delta Z2ab$, and $\Delta Z3ab$ can be calculated using the equations (11) through (21).

After the impedances are calculated, the obtained voltage, current and impedance data are saved by a data-saving memory area of the RAM (Step S24), it is judged whether or not the calculated impedance changes $\Delta Z1ab$, $\Delta Z2ab$, and $\Delta Z3ab$ are within a reference range, that is, the above described maximum tolerance range $\Delta Zd$ (Step S25). In short, it is judged whether or not the condition is normal or anomaly based on detected condition. Depending on this judgment result, further steps S26 and S27 are performed.

By performing the above steps in the battery pack 2, anomaly can be found in a display part 18 disposed in the battery pack 2. This notification becomes opportunity of exchange of the battery pack 2, therefore safety is improved.

In these processes, as described above, it is only necessary to perform the process shown in Fig.8. Depending on condition judgment (Step S11), in case where an anomaly is detected, on the basis of output of the judgment, the SW 20 is switched to turn off so as to be in the state of disconnection (OFF), the line 24 is disconnected (Step S12). According to these steps, any of charge or discharge cannot be performed in the battery pack 2 after an anomaly is detected, therefore safety is assured.

[Fifth Embodiment]

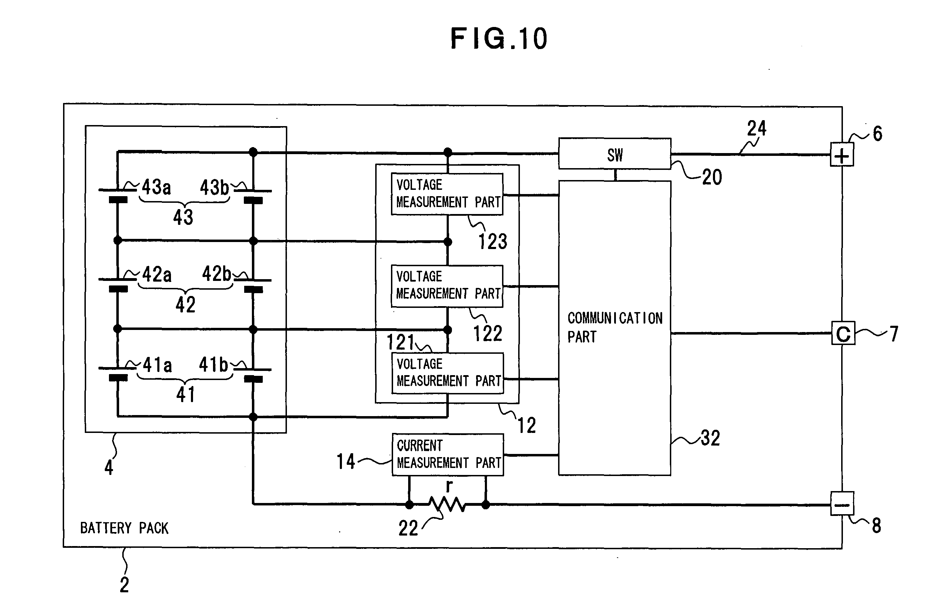

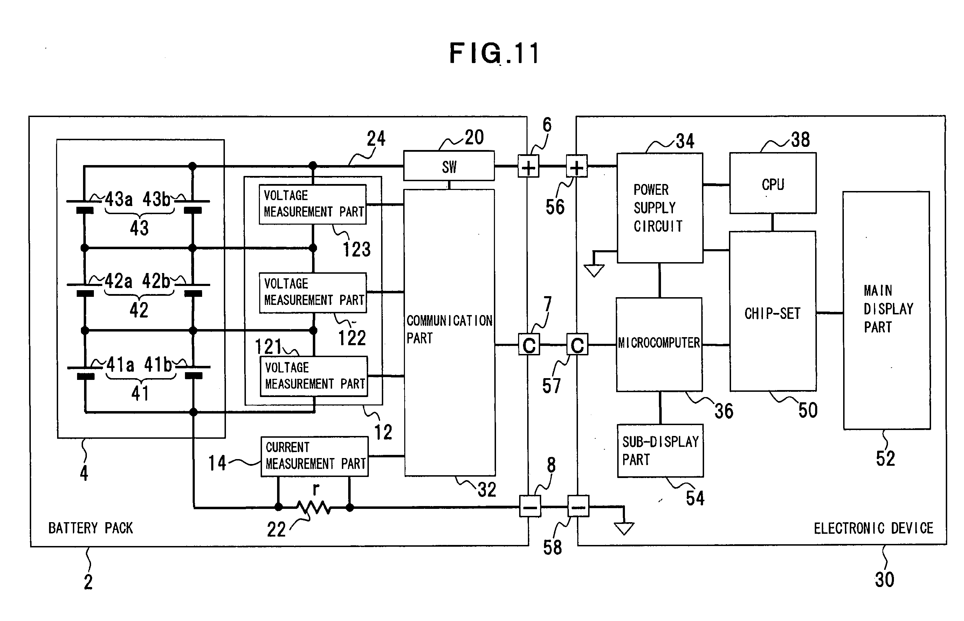

Next, a fifth embodiment of the present invention is described referring to Fig. 10 and Fig. 11. Fig. 10 is a diagram showing a configuration example of a battery pack according to the fifth embodiment of the present invention. Fig. 11 is a diagram showing a configuration example of an electronic apparatus connected with a battery pack. Same reference numerals are used in Fig. 10 and Fig. 11 for the same constituents in Fig. 5.

According to a battery pack 2 of this embodiment, measured data of assembled battery 4 is delivered to an electronic apparatus 30 (refer to Fig. 11). At the side of electronic apparatus 30, anomaly judgment and judgment display are performed based on the measured data, and open/close control of a SW 20 at the side of the battery pack 2 are performed depending on the result of judgment.

As Fig. 10 shows, the battery pack 2 has the assembled battery 4, the above described voltage measurement part 12, the current measurement part 14, the SW 20, and a communication part 32. Similarly to the anomaly detection part 16 as shown in Fig. 6, the communication part 32 has a processor 160 and a memory part 162, etc., takes in measured data of the voltage measurement part 12 and the current measurement part 14, and has a communication function that receives a control data from an electronic apparatus 30. Transmitting such measured data and receiving the control data are performed through a communication terminal 7. The SW 20 is opened or closed depending on the control data from the communication part 32. At the time of anomalies, the line 24 is disconnected.

The electronic apparatus 30 connected with the battery pack 2 of the above structure is comprised of, for example, a personal computer (PC). As shown in Fig. 11, the electronic apparatus 30 has a power supply circuit 34, a microcomputer 36, a central processing unit (CPU) 38, a chip-set 50, a main display part 52, a sub-display part 54, a power feeding terminal 56, a communication terminal 57 and a power feeding terminal 58.

In this electronic apparatus 30, the power supply circuit 34 is comprised of, for example, a DC-DC converter. Electric power is supplied to the power supply circuit 34 from the battery pack 2 for generating electric power necessary for the side of the electronic apparatus 30. The microcomputer 36 configures the above described anomaly detection part 16, and has the processor 160, the memory part 162 and a timer 164. The memory part 162 stores the control program 166 and the anomaly detection program 168 etc. The sub-display part 54 indicates output of judgment of the measured data, etc.

The CPU 38, the chip-set 50 and the main display part 52 are component parts of the side of the electronic apparatus 30. The CPU 38 performs various calculation process based on a program stored in a memory part not shown. The chip-set 50 performs data transactions and data controls. The main display part 52 is comprised of a liquid crystal display (LCD) etc to indicate information.

In this configuration, in case where an instruction of taking a measured data is transmitted to the side of the battery pack 2 from the microcomputer 36, each of the measured data by the voltage measurement part 12 and the current measurement part 14 is transmitted to the microcomputer 36 from the communication part 32. Calculation of impedance and impedance change and condition judgment can be performed at the side of the microcomputer 36. These calculation and judgment are as described above.

If it is in a normal condition as a result of judgment, its control data is delivered to the communication part 32 to connect the SW 20 and power distribution is sustained. If it is an anomaly condition as a result of judgment, its control data is delivered to the communication part 32 to open the SW 20 and power distribution is released by disconnecting the line 24. The sustaining or releasing of power distribution can be performed in either case of discharging or charging.

According to the above structure, a measured data at the side of the battery pack 2 is delivered to the electronic apparatus 30, so that the condition judgment can be performed at the side of the electronic apparatus 30, and whenever there is an anomaly in the battery pack 2, any of charge/discharge operation is prohibited and safety is assured.

[Sixth Embodiment]

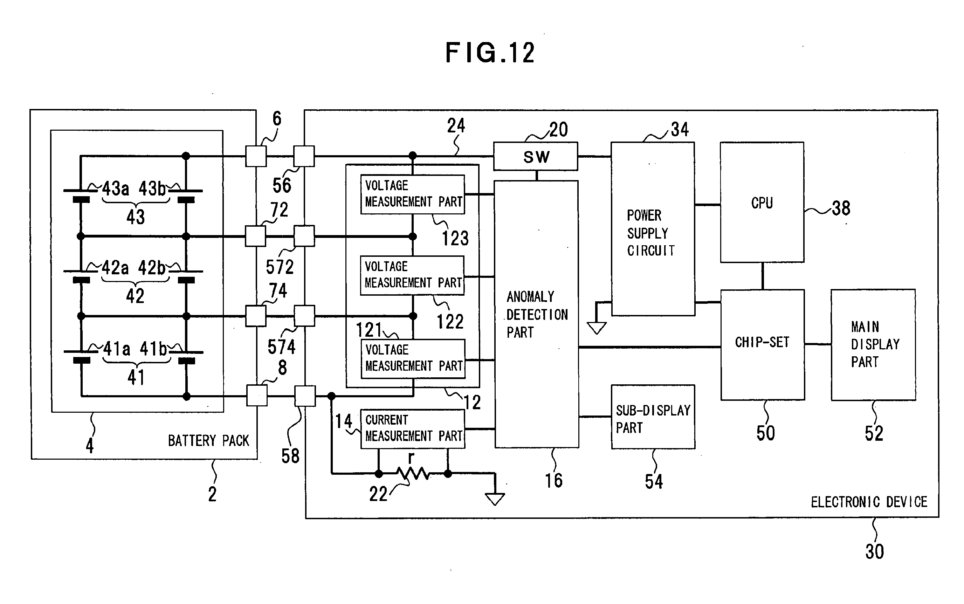

Next, a sixth embodiment of the present invention is described referring to Fig. 12. Fig. 12 is a diagram showing a configuration example of an electronic apparatus connected with a battery pack according to the sixth embodiment of the present invention. Same reference numerals are used in Fig. 12 for the same constituents in Fig. 5 and Fig. 11.

A battery pack 2 of this embodiment has, in addition to output terminals 6, 8, intermediate output terminals 72, 74 to take out outputs from battery cell blocks 41, 42 and 43 of a assembled battery 4 respectively. An electronic apparatus 30 has a voltage measurement part 12, a current measurement part 14, an anomaly detection part 16, a main display part 52, a sub-display part 54, and the SW 20. Further, the electronic apparatus 30 has intermediate power feeding terminals 572, 574 corresponding to the intermediate output terminals 72, 74. The output terminal 6 is connected with a power feeding terminal 56, the output terminal 8 is connected with a power feeding terminal 58, the intermediate output terminal 72 is connected with the intermediate power feeding terminal 572, and the intermediate output terminal 74 is connected with the intermediate power feeding terminal 574. Therefore, each voltage of the battery cell blocks 41, 42, and 43 is applied to the voltage measurement parts 121, 122 and 123 of the voltage measurement part 12, and is measured respectively. In addition, a current sensing resistor 22 is disposed between the power feeding terminal 58 and a ground (GND), and current flowing through the current sensing resistor 22 is measured by the current measurement part 14. The measured data of voltage and the current are delivered to the anomaly detection part 16 for anomaly detection.

As described above, the anomaly detection part 16 is comprised of a microcomputer and has a processor 160, a memory part 162, a timer 164 (refer to Fig. 6), etc. The processor 160 performs calculation process for the above described impedance and impedance change, judgment process, indication of the judgment result, control of the SW 20, etc. by executing various programs stored in the memory part 162. The SW 20 is disposed on the line 24 to disconnect the line 24 at the time of anomalies.

Other elements of the configuration are the same as the fifth embodiment so that their description is omitted here. The anomaly detection part 16 is exemplified in this embodiment, however, the microcomputer 36 may be used instead of the anomaly detection part 16 as shown in Fig. 11.

In this manner, the battery pack 2 installs the assembled battery 4 only and is provided with the intermediate output terminals 72, 74. Various kinds of processes, such as measurement of voltage, current, impedance and impedance change, anomaly judgment, indication of the anomaly judgment, opening/closing control of the SW 20, are performed in the electronic apparatus 30. Therefore, the structure of the battery pack 2 can be simplified, and its safety can be assured.

[Seventh Embodiment]

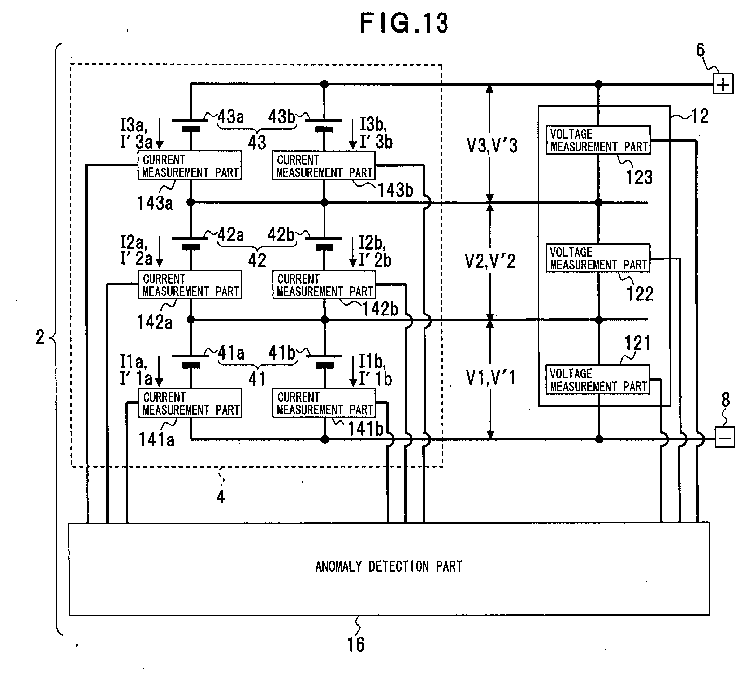

Next, a seventh embodiment of the present invention is described referring to Fig. 13. Fig. 13 is a diagram showing a configuration example of a battery pack according to the seventh embodiment of the present invention. Same reference numerals are used in Fig. 13 for the same constituents in Fig. 3, Fig. 4 and Fig. 5.

In order to measure the currents I1a, I1b, I2a, I2b, I3a, I3b, I'1a, I'1b, I'2a, I'2b, I'3a, and I' 3b of each of the battery cells, 41a, 41b, 42a, 42b, 43a, and 43b, respectively, the current measurement parts 141a, 141b, 142a, 142b, 143a, 143b are disposed for each of the battery cells, 41a, 41b, 42a, 42b, 43a, and 43b. In order to measure the voltages V1, V2, V3, V' 1, V' 2, V' 3 of each of the battery cell blocks 41, 42, and 43, the voltage measurement parts 121, 122, and 123 are disposed for each of the battery cell blocks 41, 42, and 43.

Applying these measured data to the anomaly detection part 16, impedance Z is calculated using the above-described equations (11) through (16). Impedance change ΔZ is calculated using the above-described equations (19) through (21). The calculated values are used for anomaly judgment. The judgment operation is as described above.

[Other Embodiments]

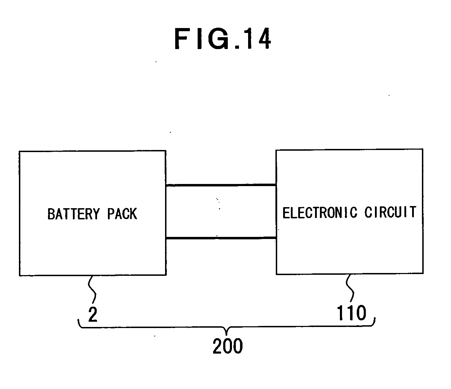

(1) In the above embodiments, by exemplifying a case for a load 11 to be connected to the battery pack 2 (refer to Fig. 2, and Fig. 4), or a case for the electronic apparatus 30 to be connected to the battery pack 2 (refer to Fig. 11 and Fig.12), the battery pack 2 and the load 11 or the electronic apparatus 30 are explained as separate components, however, as shown in Fig. 14, an electronic circuit 110 of a part of an electronic apparatus 30 such as a PC and a battery pack 2 can be integrated into an electronic apparatus 200.

(2) In the above embodiments, by measuring voltages and a charging current or a discharging current of the battery pack 2 having a plurality of battery cells, impedance or impedance change are calculated indirectly. Also, there may be a structure to directly measure impedance or impedance change of the battery pack 2.

(3) In the above embodiments, impedance change is calculated for each of the battery cell blocks 41, 42, and 43. Also, impedance change between each battery cell block of the battery cell blocks 41, 42, and 43 may be measured. Also, impedance change between each battery cell of the battery cells 41a, 41b, 42a, 42b 43a, and 43b may be measured.

As described above, according to the present invention, an anomaly of the battery pack having a plurality of the battery cells can be detected at the side of the battery pack, or at the side of the electronic apparatus installing the battery pack or being connected to the battery pack, which can be used for the control of charge/discharge of the battery pack, which contributes to the improvement of safety.

Although the most preferred embodiments of the present invention have been described hereinabove, the present invention is not intended to be limited to the description and can naturally be modified or changed by one skilled in the art based on the gist of the present invention defined in claims or disclosed in the specification, and it is needless to say that such modifications and changes are within the scope of the present invention.

**Claims**

**1.** An anomaly detection method of a battery pack with a plurality of battery cells connected in series or in parallel, comprising the step of:

detecting whether or not for an impedance of at least one of said battery cells to deviate from a stipulated range.

**2.** An anomaly detection method of a battery pack with a plurality of battery cells connected in series or in parallel, comprising the step of:

detecting whether or not for an impedance change of at least one of said battery cells to exceed a stipulated range.

**3.** The anomaly detection method of a battery pack of claim 1, further comprising the step of:

measuring an impedance of said battery cell.

4. The anomaly detection method of a battery pack of claim 1, further comprising the step of:

measuring or predicting an impedance of said battery cell on the basis of current fluctuation amount of charging current of said battery cell and the corresponding voltage fluctuation amount of said battery cell.

5. The anomaly detection method of a battery pack of claim 1, further comprising the step of:

measuring or predicting an impedance of said battery cell on the basis of current fluctuation amount of discharging current of said battery cell and the corresponding voltage fluctuation amount of said battery cell.

6. The anomaly detection method of a battery pack of claim 2, further comprising the step of:

measuring an impedance of said battery cell.

7. The anomaly detection method of a battery pack of claim 2, further comprising the step of:

measuring or predicting an impedance of said battery cell on the basis of current fluctuation amount of charging current of said battery cell and the corresponding voltage fluctuation amount of said battery cell.

8. The anomaly detection method of a battery pack of claim 2, further comprising the step of:

measuring or predicting an impedance of said battery cell on the basis of current fluctuation amount of discharging current of said battery cell and the corresponding voltage fluctuation amount of said battery cell.

9. A battery pack with a plurality of battery cells connected in series or in parallel, comprising:

a detection part detecting whether or not for an impedance of at least one of said battery cells to deviate from a stipulated range.

10. A battery pack with a plurality of battery cells connected in series or in parallel, comprising:

a detection part detecting whether or not for an impedance change of at least one of said battery cells to exceed a stipulated range.

11. The battery pack of claim 9, further comprising:

a measurement part measuring an impedance of said battery cell.

12. The battery pack of claim 9, further comprising:

a processing part calculating or predicting an impedance of said battery cell on the basis of current fluctuation amount of charging current of said battery cell and the corresponding voltage fluctuation amount of said battery cell.

13. The battery pack of claim 9, further comprising:

a processing part calculating or predicting an impedance of said battery cell on the basis of current fluctuation amount of discharging current of said battery cell and the corresponding voltage fluctuation amount of said battery cell.

14. The battery pack of claim 9, said battery pack prohibiting either or both of charging and discharging of said battery cell on the basis of a detection result by said detection part.

15. The battery pack of claim 10, further comprising:

a measurement part measuring an impedance of said battery cell.

**16.** The battery pack of claim 10, further comprising:

 a processing part calculating or predicting an impedance of said battery cell on the basis of current fluctuation amount of charging current of said battery cell and the corresponding voltage fluctuation amount of said battery cell.

**17.** The battery pack of claim 10, further comprising:

 a processing part calculating or predicting an impedance of said battery cell on the basis of current fluctuation amount of discharging current of said battery cell and the corresponding voltage fluctuation amount of said battery cell.

**18.** The battery pack of claim 10, said battery pack prohibiting either or both of charging and discharging of said battery cell on the basis of a detection result by said detection part.

**19.** An electronic apparatus connected to a battery pack with a plurality of battery cells connected in series or in parallel, comprising:

 a detection part detecting whether or not for an impedance of at least one of said battery cells to deviate from a stipulated range.

**20.** An electronic apparatus connected to a battery pack with a plurality of battery cells connected in series or in parallel, comprising:

 a detection part detecting whether or not for an impedance change of at least one of said battery cells to exceed a stipulated range.

**21.** The electronic apparatus of claim 19, further comprising:

 a measurement part measuring an impedance of each said battery cell of said battery pack.

**22.** The electronic apparatus of claim 19, further comprising:

 a processing part calculating or predicting an impedance of said battery cell on the basis of current fluctuation amount of charging current of said battery cell and the corresponding voltage fluctuation amount of said battery cell.

**23.** The electronic apparatus of claim 19, further comprising:

 a processing part calculating or predicting an impedance of said battery cell on the basis of current fluctuation amount of discharging current of said battery cell and the corresponding voltage fluctuation amount of said battery cell.

**24.** The electronic apparatus of claim 19, said electronic apparatus prohibiting either or both of charging and discharging of said battery cell on the basis of a detection result by said detection part.

**25.** The electronic apparatus of claim 19, further comprising:

 a receiving part receiving a data measured by said battery pack, corresponding to a transmitting part transmitting said data.

**26.** The electronic apparatus of claim 20, further comprising:

 a measurement part measuring an impedance of each said battery cell of said battery pack.

**27.** The electronic apparatus of claim 20, further comprising:

 a processing part calculating or predicting an impedance of said battery cell on the basis of current fluctuation amount of charging current of said battery cell and the corresponding voltage fluctuation amount of said battery cell.

**28.** The electronic apparatus of claim 20, further comprising:

a processing part calculating or predicting an impedance of said battery cell on the basis of current fluctuation amount of discharging current of said battery cell and the corresponding voltage fluctuation amount of said battery cell.

**29.** The electronic apparatus of claim 20, said electronic apparatus prohibiting either or both of charging and discharging of said battery cell on the basis of a detection result by said detection part.

**30.** The electronic apparatus of claim 20, further comprising:

a receiving part receiving a data measured by said battery pack, corresponding to a transmitting part transmitting said data.

# FIG.1

I , I′

6

V3,V′3

V2,V′2

V1,V′1

43a  43b
43

42a  42b
42

41a  41b
41

+

−

I , I′

4

8

10

2

BATTERY
CHARGER

# FIG.2

# FIG.3

# FIG.4

# F I G . 5

# FIG.6

**16**

ANOMALY DETECTION PART

**160**

| PROCESSOR | ←→ | MEMORY PART | ～162 |

| TIMER | ←→ |

**164**

CONTROL PROGRAM ～166

ANOMALY DETECTION PROGRAM

**168**

# FIG.7

```
          ┌──────────┐
          │  START   │
          └────┬─────┘
               │
               ▼
  ┌─────────────────────────┐
  │  ACQUIRE VOLTAGE DATA    │──── S1
  └───────────┬─────────────┘
              │
              ▼
  ┌─────────────────────────┐
  │  ACQUIRE CURRENT DATA    │──── S2
  └───────────┬─────────────┘
              │
              ▼
  ┌─────────────────────────┐
  │  CALCULATE IMPEDANCE     │──── S3
  └───────────┬─────────────┘
              │
              ▼
  ┌─────────────────────────┐
  │ SAVE ACQUIRED VOLTAGE    │──── S4
  │ DATA, CURRENT DATA       │
  └───────────┬─────────────┘
              │
   S5         ▼
      ◇───────────────────◇
      │ IMPEDANCE WITHIN   │  YES
      │ A REFERENCE RANGE? │─────┐
      ◇─────────┬─────────◇      │
   S6           │ NO             │
      ┌─────────▼─────────┐      │
      │ ANOMALY INDICATION│      │
      └─────────┬─────────┘      │
                │◄───────────────┘
   S7           ▼
      ◇───────────────────◇
      │    ELAPSE OF       │  NO
      │ A PREDETERMINED    │─────┐
      │      TIME?         │     │
      ◇─────────┬─────────◇      │
                │ YES
```

# FIG.8

# FIG.9

```
                    ┌─────────────┐
                    │    START    │
                    └─────────────┘
                           │
      ┌────────────────────┼
      │            ┌────────▼────────────────┐
      │            │  ACQUIRE VOLTAGE DATA    │───S21
      │            └────────┬────────────────┘
      │                     │
      │            ┌────────▼────────────────┐
      │            │  ACQUIRE CURRENT DATA    │───S22
      │            └────────┬────────────────┘
      │                     │
      │            ┌────────▼────────────────┐
      │            │ CALCULATE IMPEDANCE CHANGE│──S23
      │            └────────┬────────────────┘
      │                     │
      │            ┌────────▼────────────────┐
      │            │ SAVE ACQUIRED VOLTAGE DATA,│─S24
      │            │ CURRENT DATA, IMPEDANCE DATA│
      │            └────────┬────────────────┘
      │                     │
      │     S25             │
      │            ╱────────▼────────╲    YES
      │           ╱  IMPEDANCE CHANGE  ╲─────────┐
      │           ╲ WITHIN A REFERENCE ╱         │
      │            ╲     RANGE?       ╱          │
      │             ╲───────┬────────╱           │
      │     S26          NO │                    │
      │            ┌────────▼────────┐           │
      │            │ ANOMALY INDICATION│         │
      │            └────────┬────────┘           │
      │                     │◄───────────────────┘
      │     S27             │
      │            ╱────────▼────────╲    NO
      │           ╱   ELAPSE OF       ╲──────
      │           ╲ A PREDETERMINED TIME?╱
      │            ╲───────┬────────╱
      │                 YES │
      └─────────────────────┘
```

# FIG.10

# FIG.11

EP 1 760 477 A2

# FIG.12

EP 1 760 477 A2

# FIG.13

# FIG.14

```
┌──────────────┐      ┌──────────────────┐
│              │      │                  │
│ BATTERY PACK │══════│ ELECTRONIC CIRCUIT│
│              │══════│                  │
│              │      │                  │
└──────────────┘      └──────────────────┘
        2                    110
              200
```

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000133318 A
- JP 2004215398 A
- JP H111999252809 A
- JP 2004031273 A